# EUROPÄISCHE PATENTSCHRIFT

(11) **EP 2 688 379 B1**
(45) Veröffentlichungstag und Bekanntmachung des Hinweises auf die Patenterteilung: **28.06.2017**
(21) Anmeldenummer: 12177037.4
(22) Anmeldetag: 19.07.2012
(51) Int. Cl.: H05K 7/14

(54) **Elektronische Baugruppe der Automatisierungstechnik**
Electronic automation technology module
Module électronique de la technique d'automatisation

(43) Veröffentlichungstag der Anmeldung: 22.01.2014
(73) Patentinhaber: Siemens Aktiengesellschaft, 80333 München (DE)
(72) Erfinder: Rümpler, Hannes, 92224 Amberg (DE)

(56) Entgegenhaltungen:
- EP-A2- 0 341 751
- DE-A1- 19 822 564
- DE-A1-102010 047 632
- DE-U1- 9 319 488

## Beschreibung

Die Erfindung betrifft eine elektronische Baugruppe der Automatisierungstechnik mit einem Gehäuse, einer Rückseite und einer Vorderseite, wobei die Rückseite mit Haltemitteln zum verrasten in einem Tragsystem ausgestaltet ist und an der Vorderseite ein mit dem Gehäuse verbundener beweglicher Deckel angeordnet ist. Eine derartige Baugruppe ist bereits aus der Offenlegungsschrift DE 10 2010 047 632 A1 bekannt, wobei unter dem Deckel der Baugruppe Bedien- und Anzeigeelemente angeordnet sind.

Die Offenlegungsschrift DE 198 22 564 A1 beschreibt ein Elektronikgehäuse mit einem zweigeteilten Deckel, wobei ein erster Teil des Deckels eine Anzeigeeinheit bildet und ein zweiter Teil des Deckels eine Abdeckeinheit für Anschlusselemente bereitstellt. Die Art der Befestigungen der Deckel wird nicht näher beschrieben.

Aufgabe der Erfindung ist es eine elektronische Baugruppe mit einem Deckel bereitzustellen, wobei durch eine konstruktive Maßnahme mit den Gehäuseteilen (Deckel und Gehäuse der Baugruppe) eine kraftschlüssige und drehmomentebelastbare Verbindung zwischen dem Deckel und der Baugruppe gebildet werden kann.

Die Aufgabe wird für die eingangs genannte elektronische Baugruppe dadurch gelöst, dass in einem oberen Bereich der Vorderseite des Gehäuses eine Aufnahme angeordnet ist, wobei die Aufnahme ausgestaltet ist einen ersten Scharnierteil eines das Gehäuse und den Deckel verbindenden Scharniers mit einem Verrastmechanismus aufzunehmen, der Deckel ist dabei an einem ersten Ende als ein zweites Scharnierteil des Scharniers ausgestaltet, dazu ist senkrecht zu einer Längsachse des Deckels an dem ersten Ende in einer Umhausung des Deckels eine erste Öffnung angeordnet, in welcher ein Achskörper gesteckt ist,

wobei der erste Scharnierteil eine zweite Öffnung aufweist, in der zur Bildung einer Scharnierdrehachse ein Teilbereich des Achskörpers steckt, wobei der Deckel als eine bewegliche Frontklappe in einer Aufklapprichtung schwenkbar ist.

Bei einer weiteren Ausgestaltung weist die Umhausung einen Oberteil und einen Unterteil auf, welche mittels Verraststellen zum bilden der Umhausung miteinander verrasten, wobei das Oberteil am ersten Ende U-förmig ausgestaltet ist und dadurch ein erster Steg und ein zweiter Steg
sten Steg ist die erste Öffnung angeordnet und der zweite Steg ist mit einem Lagerzapfen ausgestaltet, welcher mit einer Lagergegenstelle in dem ersten Scharnierteil zusammenwirkt.

Für eine elektrische Verbindung zwischen dem Gehäuse und dem Deckel der elektronischen Baugruppe ist die elektronische Baugruppe vorteilhafter Weise derart ausgestaltet, dass zwischen dem Gehäuse und dem Deckel ein folienisolierter Flachleiter angeordnet ist.

Um die durch den Flachleiter hergestellte elektrische Verbindung zwischen dem Gehäuse der Baugruppe und dem Deckel belastbar auszugestalten und jederzeit eine Drehbewegung des Deckels zu dem Gehäuse im laufenden Betrieb einer elektronischen Baugruppe zuzulassen, ist es besonders vorteilhaft, wenn der folienisolierte Flachleiter einen ersten Leiterteil und einen zweiten Leiterteil aufweist und der erste Leiterteil über ein Querteil mit dem zweiten Leiterteil verbunden ist, der erste Leiterteil ist in einer ersten halben Drehung und der zweite Leiterteil ist in einer zweiten halben Drehung um die Scharnierdrehachse angeordnet, der Querteil ist parallel zur Scharnierdrehachse und senkrecht zu einer Längsrichtung des ersten und des zweiten Leiterteils angeordnet.

Mit dieser Ausgestaltung hat man nunmehr konstruktiv eine kraftschlüssige und gleichzeitig elektrische, bewegliche Verbindung zwischen dem Gehäuse der elektronischen Baugruppe und dem Deckel geschaffen. Durch die Ausgestaltung mit dem Achskörper angeordnet in der ersten Öffnung ist es möglich, eine kraftschlüssige, drehmomentbelastbare mechanische Verbindung und gleichzeitig eine elektrische Verbindung auf dem gleichen axialen Raum zu realisieren.

Um diese technische Wirkung zu erreichen wird der folienisolierte Flachleiter derart angeordnet, dass die erste halbe Drehung des ersten Leiterteils in einer um die zweite Öffnung des ersten Scharnierteils angeordneten Nut geführt ist und die zweite halbe Drehung des zweiten Leiterteils in einem Stauraum, welcher durch eine am Unterteil angeordnete Abdeckzunge und einen am Oberteil teilweise um die erste Öffnung angeordneten Führungskanal gebildet wird, geführt ist. Durch diese konstruktive Maßnahme und Formgebung der Gehäuseteile beider zu verbindenen Komponenten (Gehäuse der Baugruppe, Deckel) können die benötigten Scharnierteile innerhalb des gleichen axialen Raumes untergebracht werden. Das Scharnier besteht sozusagen aus einen festen und einen beweglichen Teil zwischen denen ein Drehmoment durch Reibkräfte erzeugt wird. Der feste Teil findet in einer Aufnahme des Gehäuses der elektronischen Baugruppe platz, der bewegliche Teil findet in einer Aufnahme der Umhausung des Deckels platz. Der folienisolierte Flachleiter wird radial um das Scharnier herum angeordnet und wechselt in einem definierten Abstand von der Drehachse, vom Gehäuse der elektronischen Baugruppe in die Umhausung des Deckels. Durch das Gehäuse der elektronischen Baugruppe wird der folienisolierte Flachleiter dabei gehalten. Durch die Umhausung des Deckels wird der folienisolierte Flachleiter während der Drehbewegung geführt.

Eine weitere Ausgestaltung sieht vor, dass in dem als eine bewegliche Frontklappe ausgestalteten Deckel ein Schaltmittel zur Bedienung der Baugruppe angeordnet ist.

Eine nochmals verbesserte Ausgestaltung sieht vor, dass in dem als eine bewegliche Frontklappe ausgestalteten Deckel ein Display zur Beobachtung der Baugruppe angeordnet ist.

Die Zeichnung zeigt ein mögliches Ausführungsbeispiel einer elektronischen Baugruppe mit einem Deckel, dabei zeigt die
- FIG 1: eine schematische, perspektivische Ansicht einer elektronischen Baugruppe,
- FIG 2: eine schematische, perspektivische Ansicht einer elektronischen Baugruppe mit einem Deckel, welcher über ein Scharnierteil in das Gehäuse der elektronischen Baugruppe eingesteckt werden kann,
- FIG 3: eine perspektivische Ansicht eines Deckels mit einem Schaltmittel und einem Display,
- FIG 4: den mit FIG 3 gezeigten Deckel in einer Unteransicht,
- FIG 5: den aus FIG 3 und FIG 4 bekannten Deckel in einer Explosionsdarstellung und
- FIG 6: in einer perspektivischen Ansicht einen folienisolierten Flachleiter.

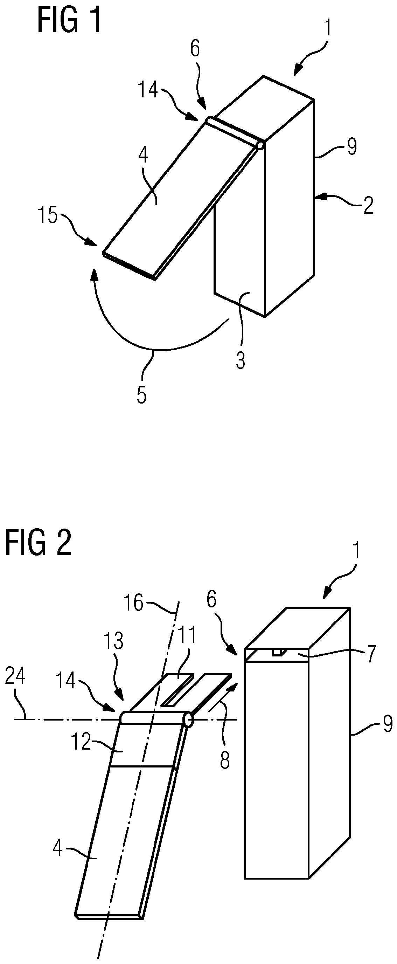

Gemäß FIG 1 ist eine elektronische Baugruppe 1 der Automatisierungstechnik mit einem Gehäuse 9, einer Rückseite 2 und einer Vorderseite 3 dargestellt. In einem oberen Bereich 6 der Vorderseite 3 ist ein Deckel 4 drehbar angeordnet. Der Deckel 4 lässt sich in einer Aufklapprichtung 5 von der elektronischen Baugruppe 1 wegbewegen. Der Deckel 4 weist ein erstes Ende 14 und ein zweites Ende 15 auf.

Gemäß FIG 2 ist die elektronische Baugruppe 1 mit dem Deckel 4 in einer zweigeteilten Darstellung abgebildet. An seinem ersten Ende 14 weist der Deckel 4 ein Scharnier 13 auf. Das Scharnier 13 umfasst ein erstes Scharnierteil 11 und ein zweites Scharnierteil 12. Das erste Scharnierteil 11 ist derart ausgestaltet, dass es in einer Einsteckrichtung 8 in eine Aufnahme 7 des Gehäuses 9 der elektronischen Baugruppe 1 eingesteckt werden kann. An der Stelle wo das erste Scharnierteil 11 und das zweite Scharnierteil 12 zusammenfinden bildet sich eine Scharnierdrehachse 24.

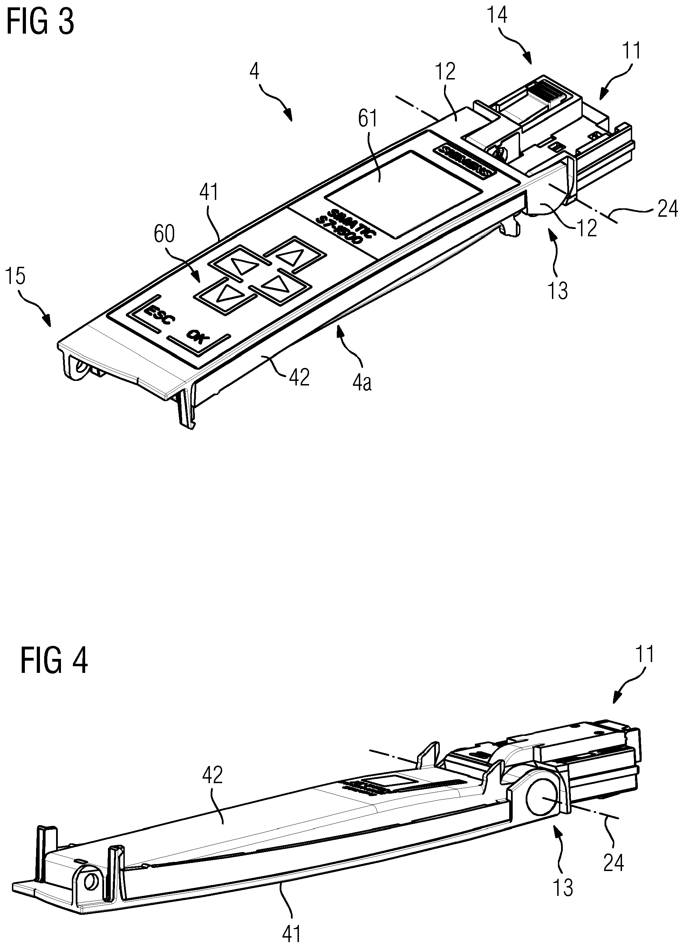

Gemäß FIG 3 ist der aus FIG 1 und FIG 2 bekannte Deckel detaillierter dargestellt. Der Deckel 4 weist nunmehr eine Umhausung 4a auf, in der ein Schaltmittel 60 und ein Display 61 angeordnet ist. Das Schaltmittel 60 ist im Bereich des zweiten Endes 15 des Deckels 4 angeordnet und weist ein Steuerungskreuz, eine Escape-Taste und eine OK-Taste auf. Das Display 61 ist im Bereich des ersten Endes 14 des Deckels 4 angeordnet. Das erste Ende 14 des Deckels 4 ist dabei als das zweite Scharnierteil 12 in den das erste Scharnierteil 11 eingepasst ist, ausgestaltet. Die Scharnierteile 11 und 12 bilden eine Scharnierdrehachse 24. Die FIG 3 zeigt den Deckel 4 in einer Sicht auf einen Oberteil 41 des Deckels 4.

Gemäß FIG 4 ist ein Unterteil 42 des Deckels 4 dargestellt.

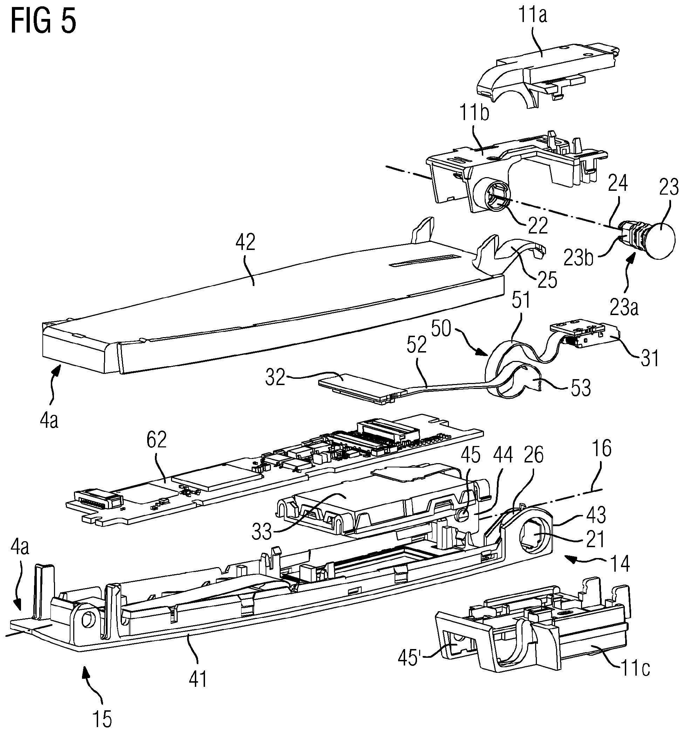

Mit der FIG 5 wird der komplette Aufbau des Deckels 4 in der Ausgestaltung einer Deckelumhausung mit elektronischen Bauteilen und Komponenten in einer Explosionsdarstellung erläutert. Das erste Scharnierteil 11 umfasst ein Abdeckteil 11a, ein Mittelteil 11b und ein Rahmenteil 11c. In dem Mittelteil 11b ist eine zweite Öffnung 22 angeordnet, welche mit einer ersten Öffnung 21 korrespondiert, welche wiederum innerhalb des zweiten Scharnierteils 12 des Deckels 4 angeordnet ist. Das zweite Scharnierteil 12 ist dabei derart ausgestaltet, dass die Umhausung 4a des Deckels 4, welche einen Oberteil 41 und einen Unterteil 42 umfasst, am ersten Ende 14 des Deckels 4, also am Oberteil 41, einen ersten Steg 43 und einen zweiten Steg 44 aufweist, wodurch das erste Ende 14 U-förmig ausgestaltet ist. Dabei ist in dem ersten Steg 43 die erste Öffnung 21 angeordnet und der zweite Steg 44 weist einen Lagerzapfen 45 auf, welcher mit einer Lagergegenstelle 45' in dem ersten Scharnierteil 11 zusammenwirkt.

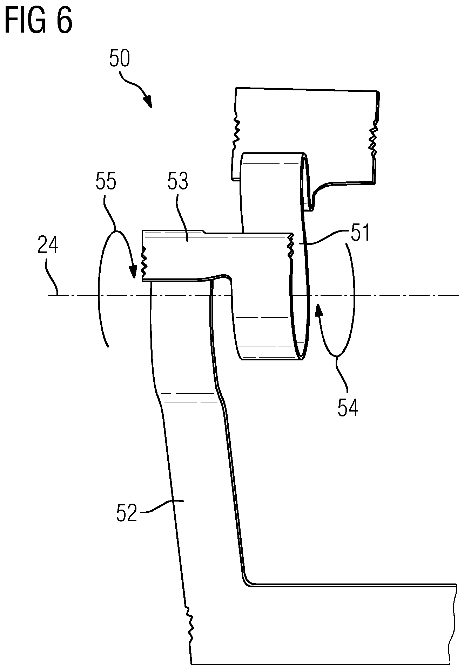

Innerhalb der Umhausung 4a des Deckels 4 ist ein folienisolierter Flachleiter 50 mit einem ersten Leiterteil 51 und einem zweiten Leiterteil 52 angeordnet. Der erste Leiterteil 52 ist über ein Querteil 53 mit dem zweiten Leiterteil 52 verbunden. Der erste Leiterteil 51 ist in einer ersten halben Drehung 54 (siehe auch FIG 6) und der zweite Leiterteil 52 ist in einer zweiten halben Drehung 55 um die Scharnierdrehachse 24 angeordnet. Der Querteil 53 ist parallel zur Scharnierdrehachse 24 und senkrecht zu einer Längsrichtung des ersten und des zweiten Leiterteils 51,52 angeordnet. Eine Displayeinheit 33 ist in dem Oberteil 41 angeordnet. Eine Leiterplatte 22 ist zwischen dem Unterteil 42 und der Displayeinheit 33 angeordnet. Sind alle Komponenten zusammengesteckt und insbesondere das Unterteil 41 und das Oberteil 42 über Rastnasen miteinander verrastet so kann über einen Achskörper 23 das aus dem ersten Scharnierteil 11 und dem zweiten Scharnierteil 12 gebildete Scharnier 13 funktionstüchtig gemacht werden. Der Achskörper 23 weist einen ersten Teilbereich 23a und einen zweiten Teilbereich 23b auf. Der erste Teilbereich 23a des Achskörpers 23 steckt dabei in der ersten Öffnung 21 und der zweite Teilbereich 23b des Achskörpers 23 steckt dabei in der zweiten Öffnung 22 und bildet somit eine kraftschlüssige, drehmomentstabile Scharnierverbindung.

Für eine Verbindung der Leiterplatte 62 über den folienisolierten Flachleiter 50 mit einer elektronischen Komponente innerhalb des Gehäuses der elektronischen Baugruppe 1, weist der folienisolierte Flachleiter 50 an einem ersten Ende einen ersten Steckverbinder 31 und an einem zweiten Ende einen zweiten Steckverbinder 32 auf.

Gemäß der FIG 6 ist der folienisolierte Flachleiter 50 in einer perspektivischen Darstellung abgebildet. Der folienisollierte Flachleiter 50 umfasst einen ersten Leiterteil 51 und einen zweiten Leiterteil 52, welche über ein Querteil 53 miteinander verbunden sind. Um einen dauerhaft drehbaren Übergang von dem Gehäuse der elektronischen Baugruppe zu dem Deckel 4 zu schaffen, ist der folienisolierte Flachleiter 50 derart ausgestaltet, dass der erste Leiterteil 51 in einer ersten halben Drehung und der 54 und der zweite Leiterteil 52 in einer zweiten halben Drehung 55 um die Scharnierdrehachse 24 und senkrecht zu einer Längsrichtung des ersten und zweiten Leiterteils 51,52 angeordnet ist. Im eingebauten Zustand (siehe FIG 5) ist die erste halbe Drehung 54 des ersten Leiterteils 51 in einer um die zweite Öffnung 22 des ersten Scharnierteils 11 angeordneten Nut 20 geführt und die zweite halbe Drehung 55 des zweiten Leiterteils 52 ist in einem Stauraum 19, welcher durch eine am Unterteil 42 angeordnete Abdeckzunge 25 und einen am Oberteil 41 teilweise um die erste Öffnung 21 angeordneten Führungskanal 26 gebildet wird, geführt.

## Patentansprüche

1. Elektronische Baugruppe (1) der Automatisierungstechnik mit einem Gehäuse (9), einer Rückseite (2) und einer Vorderseite (3), wobei die Rückseite (2) mit Haltemitteln zum Verrasten in einem Tragsystem ausgestaltet ist und an der Vorderseite (3) ein mit dem Gehäuse (9) verbundener beweglicher Deckel (4) angeordnet ist,
**dadurch gekennzeichnet, dass** in einem oberen Bereich (6) der Vorderseite (3) des Gehäuses (9) eine Aufnahme (7) angeordnet ist, wobei die Aufnahme (7) ausgestaltet ist ein erstes Scharnierteil (11) eines das Gehäuse (9) und den Deckel (4) verbindenden Scharniers (13) mit einem Verrastmechanismus aufzunehmen, der Deckel (4) ist dabei an einem ersten Ende (14) als ein zweites Scharnierteil (12) des Scharniers (13) ausgestaltet, dazu ist senkrecht zu einer Längsachse (16) des Deckels (4) an dem ersten Ende (14) in einer Umhausung (4a) des Deckels (4) eine erste Öffnung (21) angeordnet, in welche ein Achskörper (23) gesteckt ist, wobei der erste Scharnierteil (11) eine zweite Öffnung (22) aufweist, in der zur Bildung einer Scharnierdrehachse (24) ein Teilbereich (23a,23b) des Achskörpers (23) steckt, wobei der Deckel (4) als eine bewegliche Frontklappe in einer Aufklapprichtung (5) schwenkbar ist.

2. Elektronische Baugruppe (1) nach Anspruch 1, wobei die Umhausung (4a)
ein Oberteil (41) und
ein Unterteil (42) umfasst, welche mittels Verraststellen zum bilden der Umhausung (4a) miteinander verrasten, wobei das Oberteil (41) am ersten Ende (14) u-förmig ausgestaltet ist und dadurch ein erster Steg (43) und ein zweiter Steg (44) gebildet ist, in dem ersten Steg (43) ist die erste Öffnung (21) angeordnet und der zweite Steg (44) ist mit einem Lagerzapfen (45) ausgestaltet, welcher mit einer Lagergegenstelle (45') in dem ersten Scharnierteil (11) zusammenwirkt.

3. Elektronische Baugruppe (1) nach Anspruch 1 oder 2, wobei zwischen Gehäuse (9) und Deckel (4) ein folienisolierter Flachleiter (50) angeordnet ist.

4. Elektronische Baugruppe (1) nach Anspruch 3, wobei der folienisolierte Flachleiter (50) einen ersten Leiterteil (51) und einen zweiten Leiterteil (52) aufweist und der erste Leiterteil (51) über ein Querteil (53) mit dem zweiten Leiterteil (52) verbunden ist, der erste Leiterteil (51) ist in einer ersten halben Drehung (54) und der zweite Leiterteil (52) ist in einer zweiten halben Drehung (55) um die Scharnierdrehachse (24) angeordnet, der Querteil (53) ist parallel zur Scharnierdrehachse (24) und senkrecht zu einer Längsrichtung des ersten und des zweiten Leiterteils (51,52) angeordnet.

5. Elektronische Baugruppe (1) nach Anspruch 4, wobei die erste halbe Drehung (54) des ersten Leiterteils (51) in einer um die zweite Öffnung (22) des ersten Scharnierteil (11) angeordneten Nut (20) geführt ist und die zweite halbe Drehung (55) des zweiten Leiterteils (52) in einem Stauraum (19), welcher durch eine am Unterteil (42) angeordnete Abdeckzunge (25) und einen am Oberteil (41) teilweise um die erste Öffnung (21) angeordneten Führungskanal (26) gebildet wird, geführt ist.

6. Elektronische Baugruppe (1) nach einem der Ansprüche 1 bis 5, wobei in dem als eine bewegliche Frontklappe ausgestalteten Deckel (4) ein Schaltmittel (60) zur Bedienung der Baugruppe (1) angeordnet ist.

7. Elektronische Baugruppe (1) nach einem der Ansprüche 1 bis 6, wobei in dem als eine bewegliche Frontklappe ausgestalteten Deckel (4) ein Display (61) zur Beobachtung der Baugruppe (1) angeordnet ist.

## Claims

1. Electronic module (1) in automation engineering having a housing (9), a back (2) and a front (3), the back (2) being configured with retaining means for latching in a support system and a movable cover (4) connected to the housing (9) being disposed at the front (3),
**characterised in that** a receptacle (7) is disposed in a top region (6) of the front (3) of the housing (9), the receptacle (7) being configured to receive a first hinge piece (11) of a hinge (13), with a latching mechanism, connecting the housing (9) and the cover (4), the cover (4) being configured at a first end (14) as a second hinge piece (12) of the hinge (13), for which purpose a first opening (21) into which an axial casing (23) is inserted is disposed perpendicular to a longitudinal axis (16) of the cover (4) at the first end (14) in an enclosure (4a) of the cover (4), the first hinge piece (11) having a second opening (22) into which a partial region (23a,23b) of the axial casing (23) is inserted to form an axis of rotation (24) of the hinge, it being possible to rotate the cover (4) as a movable front flap in an opening direction (5).

2. Electronic module (1) according to claim 1, the enclosure (4a) comprising a top part (41) and a bottom part (42) which latch together by means of latching points to form the enclosure (4a), the top part (41) being configured as U-shaped at the first end (14) and as a result a first web (43) and a second web (44) being formed, the first opening (21) being disposed in the first web (43) and the second web (44) being configured with a bearing journal (45) which interacts with a bearing receiver (45') in the first hinge piece (11).

3. Electronic module (1) according to claim 1 or 2, a foil-insulated flat conductor (50) being disposed between housing (9) and cover (4).

4. Electronic module (1) according to claim 3, the foil-insulated flat conductor (50) having a first conductor part (51) and a second conductor part (52) and the first conductor part (51) being connected to the second conductor part (52) via a cross-piece (53), the first conductor part (51) being disposed in a first half rotation (54) and the second conductor part (52) being disposed in a second half rotation (55) around the axis of rotation (24) of the hinge, the cross-piece (53) being disposed parallel to the axis of rotation (24) of the hinge and perpendicular to a longitudinal direction of the first and second conductor parts (51,52).

5. Electronic module (1) according to claim 4, the first half rotation (54) of the first conductor part (51) being guided in a groove (20) disposed around the second opening (22) of the first hinge piece (11) and the second half rotation (55) of the second conductor part (52) being guided in a reservoir (19) which is formed by a covering tongue (25) disposed at the bottom part (42) and a guide channel (26) disposed at the top part (41) partially around the first opening (21).

6. Electronic module (1) according to one of claims 1 to 5, a switching means (60) for operating the module (1) being disposed in the cover (4) configured as a movable front flap.

7. Electronic module (1) according to one of claims 1 to 6, a display (61) for monitoring the module (1) being disposed in the cover (4) configured as a movable front flap.

## Revendications

1. Module ( 1 ) électronique de la technique d'automatisation, comprenant un boîtier ( 9 ) , une face ( 2 ) arrière, une face ( 3 ) avant, la face ( 2 ) arrière étant conformée en ayant des moyens de retenue pour l'encliquetage dans un système porteur et un couvercle ( 4 ) mobile relié au boîtier ( 9 ) étant monté sur la face ( 3 ) avant,
**caractérisé en ce qu'**il est prévu un logement ( 7 ) dans la partie ( 6 ) supérieure de la face ( 3 ) avant du boîtier ( 9 ), le logement ( 7 ) étant conformé pour recevoir, par un mécanisme d'encliquetage, une première partie ( 11 ) d'une charnière ( 13 ), reliant le boîtier ( 9 ) et le couvercle ( 4 ), le couvercle ( 4 ) étant conformé à cet effet, à une première extrémité ( 14 ), sous la forme d'une deuxième partie ( 12 ) de la charnière ( 13 ), étant ménagée à cet effet perpendiculairement à un axe ( 16 ) longitudinal du couvercle ( 4 ) sur la première extrémité ( 14 ), dans une enveloppe ( 4a ) du couvercle ( 4 ), une première ouverture ( 21 ), dans laquelle est enfilée une pièce ( 3 ) d'axe, la première partie ( 11 ) de la charnière ayant une deuxième ouverture ( 22 ), dans laquelle est enfilée, pour former un charnon ( 24 ), une région ( 23a, 23b ) partielle de la pièce ( 23 ) d'axe, le couvercle ( 4 ) pouvant, sous la forme d'un volet avant mobile, pivoter dans une direction ( 5 ) de rabattement.

2. Module ( 1 ) électronique suivant la revendication 1, dans lequel l'enveloppe ( 4a ) comprend
une partie ( 41 ) supérieure et
une partie ( 42 ) inférieure, qui sont encliquetées l'une à l'autre au moyen de points d'encliquetage, pour former l'enveloppe ( 4a ), la partie ( 41 ) supérieure étant conformée en forme de u à la première extrémité ( 14 ) et formant ainsi un premier flasque ( 43 ) et un deuxième flasque ( 44 ), la première ouverture ( 21 ) étant prévue dans le premier flasque ( 43 ) et le deuxième flasque ( 44 ) étant conformé en ayant un tourillon ( 45 ), qui coopère avec un point ( 45' ) antagoniste de palier de la première partie ( 11 ) de charnière.

3. Module ( 1 ) électronique suivant la revendication 1 ou 2, dans lequel un conducteur ( 50 ) plat à isolation par une feuille est disposé entre le boîtier ( 9 ) et le couvercle ( 4 ).

4. Module ( 1 ) électronique suivant la revendication 3, dans lequel le conducteur ( 50 ) plat à isolation par une feuille a une première partie ( 51 ) et une deuxième partie ( 52 ) et la première partie ( 51 ) est reliée à la deuxième partie ( 52 ) par une partie ( 53 ) transversale, la première partie ( 51 ) est disposée suivant une première demi-rotation ( 54 ) et la deuxième partie ( 52 ) suivant une deuxième demi-rotation ( 55 ) autour du charnon ( 24 ), la partie ( 53 ) transversale est parallèle au charnon ( 24 ) et est perpendiculaire à une direction longitudinale de la première et de la deuxième partie ( 51, 52 ) de conducteur.

5. Module ( 1 ) électronique suivant la revendication 4, dans lequel la première demi-rotation ( 54 ) de la première partie ( 51 ) de conducteur est guidée dans une rainure ( 20 ) disposée autour de la deuxième ouverture ( 22 ) de la première partie ( 11 ) de la charnière et la deuxième demi-rotation ( 55 ) de la deuxième partie ( 52 ) de conducteur est guidée dans l'espace ( 19 ) de retenue, qui est formé par une languette ( 25 ) de recouvrement disposée sur la partie ( 42 ) inférieure et par un conduit ( 26 ) de guidage disposé sur la partie ( 41 ) supérieure en partie autour de la première ouverture ( 21 ).

6. Module ( 1 ) électronique suivant l'une des revendications 1 à 5, dans lequel un moyen ( 60 ) de commutation, pour faire fonctionner le module ( 1 ), est monté dans le couvercle ( 4 ) conformé en volet avant mobile.

7. Module ( 1 ) électronique suivant l'une des revendications 1 à 6, dans lequel un affichage ( 61 ) d'observation du module ( 1 ) est monté dans le couvercle ( 4 ) conformé en volet avant mobile.
